# EUROPEAN PATENT APPLICATION

(11) **EP 4 589 639 A1**
(43) Date of publication of application: **23.07.2025**
(21) Application number: 23879668.4
(22) Date of filing: 10.10.2023
(51) Int. Cl.: H01L 21/50, H01L 33/48

(54) **RECEPTION SUBSTRATE, METHOD FOR MANUFACTURING RECEPTION SUBSTRATE, LIFTING METHOD, HOLDING METHOD, AND METHOD FOR CLEANING MICROSTRUCTURE**

(30) Priority: 21.10.2022 JP 2022168951
(71) Applicant: SHIN-ETSU CHEMICAL CO., LTD., Tokyo 1000005 (JP)
(72) Inventor: TOYOSHIMA, Takeharu, Annaka-shi, Gunma 379-0224 (JP); OGAWA, Yoshinori, Tokyo 100-0005 (JP); KONDO, Kazunori, Tokyo 100-0005 (JP); OZAI, Toshiyuki, Annaka-shi, Gunma 379-0224 (JP)
(74) Representative: Meissner Bolte Partnerschaft mbB
(86) International application number: PCT/JP2023/036795
(87) International publication number: WO 2024/085025

(57) **Abstract**

The present invention is a receiving substrate for receiving a microstructure formed on a supply substrate and transferred by laser lift-off, wherein the receiving substrate includes a curable resin layer on a face to which the microstructure is to be transferred. Thus, the present invention can provide a receiving substrate that is capable of receiving a microstructure while suppressing damage, and also holding the microstructure while controlling displacement and a tilt thereof.

## Description

### TECHNICAL FIELD

The present invention relates to: a receiving substrate to be used for transferring a microstructure such as a mini light-emitting diode (hereinafter also referred to as mini-LED) and a micro light-emitting diode (hereinafter also referred to as micro-LED); a method for producing the receiving substrate; a LIFT (LIFT: Laser-Induced Forward Transfer) method for transferring a microstructure; a method for holding a microstructure onto a receiving substrate; and a method for cleaning a microstructure.

### BACKGROUND ART

Recently, along with miniaturization of semiconductor devices, microstructure transfer technology using adhesive resin is attracting attention as a means of assembling electric and electrical appliance products using semiconductor devices. In particular, technological development for manufacturing LED displays for use in signage, TVs, medical applications, in-vehicle displays, smartphones, etc. is becoming active, which transfers a large number of, i.e. tens of thousands of mini-LEDs (LED element with a short side of 100 µm or more to several hundreds µm) or micro-LEDs (LED element with a short side of 100 µm or less, further 50 µm or less) at once.

A method for transferring microstructures such as micro-LEDs using a silicone adhesive cured product as a donor substrate or a stamp material for transfer, and a mounting method on a circuit board have been developed so far (Patent Document 1).

Meanwhile, as a method for electrically connecting a transferred microstructure such as a LED element to a circuit board, a known method includes: applying solder particles (hereinafter also referred to as Bump) onto an electrode of a microstructure; mounting the microstructure on wiring of a circuit board; and thereafter performing reflow to melt the solder component contained in the Bump to make it conductive. In a case of transferring such microstructure including the Bump, there has been a problem that the Bump often has a rounded shape, and thus a mounting posture thereof on a donor plate is not uniform and a tilt relative to a plate plane occurs. Moreover, after laser lift-off (hereinafter also referred to as LLO) of a blue LED device, for example, Ga is attached to a surface of the microstructure. There has been a problem that when hydrochloric acid aqueous solution is used as a cleaning liquid to remove the Ga, the solder component dissolves at the same time to cause compositional change and increase in a melting point during the reflow, which affects a next step. Furthermore, the microstructure often falls off due to impact during cleaning.

### CITATION LIST

### PATENT LITERATURE

Patent Document 1: JP 2021-34610 A

### SUMMARY OF INVENTION

### TECHNICAL PROBLEM

The present invention has been made to solve the above problems, and aims to provide: a receiving substrate capable of receiving a microstructure while suppressing damage, and also holding the microstructure while controlling displacement and a tilt thereof; a method for producing such receiving substrate; a LIFT method capable of transferring a microstructure from a supply substrate to a receiving substrate while suppressing damage, and holding the microstructure while controlling displacement and a tilt thereof; a holding method capable of controlling displacement and a tilt of a microstructure; and a cleaning method capable of cleaning a microstructure while preventing falling off, displacement, and a tilt thereof.

### SOLUTION TO PROBLEM

To achieve the above object, the present invention provides a receiving substrate for receiving a microstructure formed on a supply substrate and transferred by laser lift-off,
wherein the receiving substrate includes a curable resin layer on a face to which the microstructure is to be transferred.

The receiving substrate of the present invention can prevent local stress from being applied to the microstructure during laser lift-off (LLO) and firmly hold the microstructure. Accordingly, with the receiving substrate of the present invention, it is possible to receive the microstructure while suppressing damage, and also hold the microstructure while controlling displacement and a tilt thereof.

For example, the curable resin layer is a photo-curable or thermosetting resin layer.

While the curable resin layer is not particularly limited as long as it is curable, it may be a photo-curable or thermosetting resin layer, for example.

For example, the curable resin layer may be in a **B-**stage.

The curable resin layer may be in a B-stage, or is semi-cured. Such resin layer can hold the microstructure without displacing or tilting by receiving the microstructure and then being subjected to a secondary curing.

The curable resin layer is preferably in a gel form.

The resin layer in a gel form can more reliably prevent damage to the microstructure during laser lift-off.

For example, the curable resin layer may be a silicone-based gel layer.

The curable resin layer can be, for example, a silicone-based gel layer, but is not limited thereto.

The curable resin layer preferably has tackiness to the microstructure.

Such resin layer can further prevent displacement of the received microstructure.

The curable resin layer preferably exhibits increased hardness by virtue of curing thereof.

The resin layer that exhibits increased hardness by virtue of curing thereof can further control displacement and a tilt of the microstructure after the curing.

Alternatively, the curable resin layer preferably exhibits increased adhesive strength to the microstructure by virtue of curing thereof, or exhibits increased holding power for the microstructure by virtue of curing thereof.

Such resin layer can more reliably control displacement and a tilt of the microstructure after it cures.

Alternatively, the curable resin layer is preferably to be in a rubber form by virtue of curing thereof.

The resin layer that is to be in a rubber form by virtue of curing thereof can further control displacement and a tilt of the microstructure after the curing.

In this case, for example, the curable resin layer may have a storage modulus at 25°C of 10 to 1000 Pa, and exhibits a storage modulus of 1 MPa to 30 GPa by virtue of curing thereof.

The curable resin layer may exhibit, for example, such an increased storage modulus by virtue of curing thereof.

Additionally, the present invention provides a method for producing a receiving substrate having a curable resin layer, including the steps of:
forming a resin layer on one face of a substrate for producing a receiving substrate, the resin layer being capable of undergoing at least two types of curing reactions; and
performing a first type of curing reaction to partially cure the resin.

Such production method can produce a receiving substrate having a curable resin layer by performing the step of performing a first type of curing reaction to partially cure the resin. This receiving substrate can prevent local stress from being applied to the microstructure during laser lift-off, and firmly hold the microstructure. Accordingly, the receiving substrate thus produced can receive the microstructure by laser lift-off while suppressing damage, and also hold the microstructure while controlling displacement and a tilt thereof.

For example, the at least two types of curing reactions can include a combination of a photo-curing reaction and a thermosetting reaction, a combination of thermosetting reactions with different curing start temperatures, or a combination of photo-curing reactions with different curing wavelengths.

Although the combination of the curing reactions is not particularly limited, the combinations as described above can be employed, for example.

In this case, for example, the at least two types of curing reactions can include a combination of at least two selected from the group consisting of a radical curing system, a cationic curing system, an anionic curing system, an addition curing system, and a condensation curing system.

Although the combination of the curing reactions is not particularly limited, the combinations as described above can be employed, for example.

Additionally, the present invention provides a LIFT method for transferring a microstructure formed on a supply substrate to a receiving substrate by laser lift-off, wherein
the microstructure has a projection on a face opposite to the receiving substrate, and
the receiving substrate includes a curable resin layer on a face to which the microstructure is to be transferred,
the method including:
   pressing the microstructure against the curable resin layer to embed the projection in the curable resin layer;
   curing the curable resin layer with the projection embedded in the curable resin layer, thereby holding the microstructure onto the receiving substrate; and
   performing laser lift-off with the microstructure held onto the receiving substrate.

According to such LIFT method, by virtue of performing laser lift-off with the projection of the microstructure embedded in the curable resin layer, local stress can be prevented from being applied to the microstructure during the laser lift-off. Accordingly, with the LIFT method of the present invention, it is possible to transfer also the microstructure having the projection from the supply substrate to the receiving substrate while preventing damage. Moreover, the curable resin layer of the receiving substrate to be used in the LIFT method of the present invention can exhibit high hardness by virtue of curing thereof while holding the microstructure. Accordingly, with the LIFT method of the present invention, it is possible to hold the microstructure onto the receiving substrate while controlling displacement and a tilt of the received microstructure.

Additionally, the present invention provides a method for holding a microstructure having a projection onto a receiving substrate,
wherein the receiving substrate has a curable resin layer on a face onto which the microstructure is to be held,
the method including:
   pressing the microstructure against the curable resin layer to embed the projection in the curable resin layer; and
   curing the curable resin layer while keeping the projection embedded in the curable resin layer, thereby holding the microstructure onto the receiving substrate.

With such holding method, by virtue of the curing the curable resin layer with the projection of the microstructure embedded in the curable resin layer, the microstructure can be held onto the receiving substrate while preventing damage, displacement, and a tilt of the microstructure.

Furthermore, the present invention provides a method for cleaning a microstructure, including:
transferring the microstructure to the receiving substrate by the LIFT method of the present invention, and thereafter cleaning the microstructure with an acidic or alkaline cleaning liquid.

As described above, the LIFT method of the present invention can hold the microstructure onto the receiving substrate while controlling displacement and a tilt of the received microstructure. Therefore, with the cleaning method of the present invention, it is possible to clean the microstructure while preventing falling off, displacement, and a tilt of the microstructure.

Furthermore, the present invention provides a method for cleaning a microstructure having a projection, including:
pressing the microstructure against a curable resin layer to embed the projection in the curable resin layer; and
curing the curable resin layer and thereafter cleaning the microstructure with an acidic or alkaline cleaning liquid in a state that the projection of the microstructure is covered with the resin layer without any space or any air bubbles in the resin layer within 5 µm from the projection.

According to such cleaning method, by embedding the projection of the microstructure in the curable resin layer, curing this curable resin layer, and then cleaning the microstructure in a state that the projection of the microstructure is covered with the resin layer without any space or any air bubbles in the resin layer from 5 µm from the projection, falling off, displacement, and a tilt of the microstructure due to the cleaning can be prevented.

### ADVANTAGEOUS EFFECTS OF INVENTION

As described above, the inventive receiving substrate can receive a microstructure by laser lift-off while suppressing damage, and also control displacement and a tilt of the microstructure.

Furthermore, the inventive method for producing a receiving substrate can produce a receiving substrate that is capable of receiving a microstructure by laser lift-off while suppressing damage, and also controlling displacement and a tilt of the microstructure.

Furthermore, with the inventive LIFT method, it is possible to transfer also a microstructure having a projection from a supply substrate to a receiving substrate while preventing damage. Additionally, with the inventive LIFT method, it is possible to hold the microstructure onto the receiving substrate while controlling displacement and a tilt of the received microstructure.

Furthermore, the inventive holding method can hold a microstructure onto a receiving substrate while controlling displacement and a tilt of the microstructure.

Furthermore, the inventive cleaning method can clean a microstructure while preventing falling off, displacement, and a tilt thereof.

### BRIEF DESCRIPTION OF DRAWINGS

FIG. 1 is a schematic illustration showing an example of a receiving substrate according to the present invention;
FIG. 2 is a schematic illustration showing an example of a method for producing a receiving substrate according to the present invention;
FIG. 3 is a schematic illustration showing an example of a supply substrate which can be used in the present invention;
FIG. 4 is a schematic illustration showing an example of a LIFT method according to the present invention;
FIG. 5 is a schematic illustration showing bonding and secondary curing in an example of LIFT according to of the present invention;
FIG. 6 is a detailed illustration of FIG. 5(C);
FIG. 7 is a schematic illustration in another aspect of a stacked substrate shown in FIG. 6;
FIG. 8 is a schematic illustration showing LLO and debonding in an example of a LIFT method according to the present invention;
FIG. 9 is a schematic illustration showing an example of a cleaning method according to the present invention;
FIG. 10 shows photographs of microstructures after transfer, the debonded microstructures subsequent to this transfer, and the cleaned microstructures subsequent to this debonding in Example 1; and
FIG. 11 shows photographs of microstructures after transfer, the debonded microstructures subsequent to this transfer, and the cleaned microstructures subsequent to this debonding in a reference example.

### DESCRIPTION OF EMBODIMENTS

As described above, it has been demanded to develop: a receiving substrate capable of receiving a microstructure while suppressing damage, and also holding the microstructure while controlling displacement and a tilt thereof; a method for producing such a receiving substrate; a LIFT method capable of transferring a microstructure from a supply substrate to a receiving substrate while suppressing damage, and holding the microstructure while controlling displacement and a tilt thereof; a holding method capable of controlling displacement and a tilt of a microstructure; and a cleaning method capable of cleaning a microstructure while preventing falling off, displacement, and a tilt thereof.

As a result of an intensive investigation on the above problems, the present inventors have found that the use of a receiving substrate including a curable resin layer enables to receive a microstructure by laser lift-off while suppressing damage, and also control displacement and a tilt of the microstructure, and completed the present invention based on this finding.

Thus, the present invention is a receiving substrate for receiving a microstructure formed on a supply substrate and transferred by laser lift-off,
wherein the receiving substrate includes a curable resin layer on a face to which the microstructure is to be transferred.

Furthermore, the present invention is a method for producing a receiving substrate having a curable resin layer, including the steps of:
forming a resin layer on one face of a substrate for producing a receiving substrate, the resin layer being capable of undergoing at least two types of curing reactions; and
performing a first type of curing reaction to partially cure the resin.

Furthermore, the present invention is a LIFT method for transferring a microstructure formed on a supply substrate to a receiving substrate by laser lift-off, wherein
the microstructure has a projection on a face opposite to the receiving substrate, and
the receiving substrate includes a curable resin layer on a face to which the microstructure is to be transferred,
the method including:
   pressing the microstructure against the curable resin layer to embed the projection in the curable resin layer;
   curing the curable resin layer with the projection embedded in the curable resin layer, thereby holding the microstructure onto the receiving substrate; and
   performing laser lift-off with the microstructure held onto the receiving substrate.

Furthermore, the present invention is a method for holding a microstructure having a projection onto a receiving substrate,
wherein the receiving substrate has a curable resin layer on a face onto which the microstructure is to be held,
the method including:
   pressing the microstructure against the curable resin layer to embed the projection in the curable resin layer; and
   curing the curable resin layer while keeping the projection embedded in the curable resin layer, thereby holding the microstructure onto the receiving substrate.

Furthermore, the present invention is a method for cleaning a microstructure, including:
transferring the microstructure to the receiving substrate by the LIFT method of the present invention, and thereafter cleaning the microstructure with an acidic or alkaline cleaning liquid.

Furthermore, the present invention is a method for cleaning a microstructure having a projection, including:
pressing the microstructure against a curable resin layer to embed the projection in the curable resin layer; and
curing the curable resin layer and thereafter cleaning the microstructure with an acidic or alkaline cleaning liquid in a state that the projection of the microstructure is covered with the resin layer without any space or any air bubbles in the resin layer within 5 µm from the projection.

Hereinafter, the present invention will be described in detail. However, the present invention is not limited thereto.

### Receiving Substrate

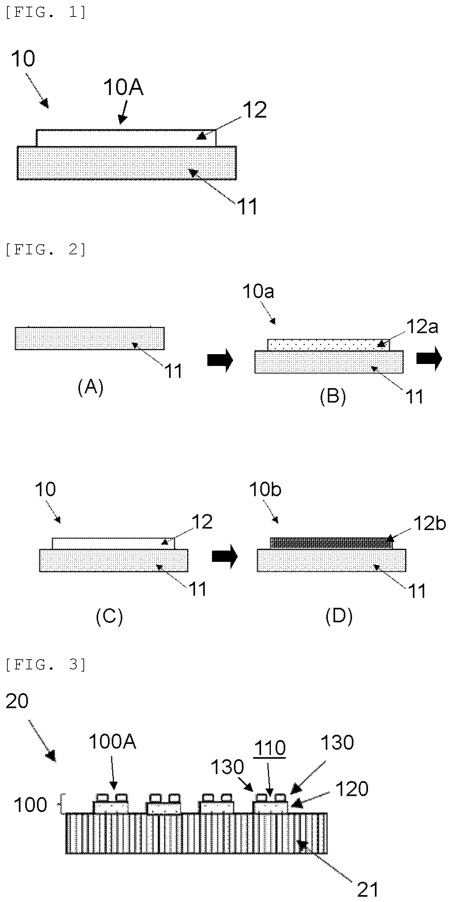

FIG. 1 shows a schematic illustration of an example of a receiving substrate according to the present invention.

A receiving substrate 10 shown in FIG. 1 is the receiving substrate 10 for receiving a microstructure formed on a supply substrate and transferred by laser lift-off. The supply substrate and the microstructure will be described later.

The receiving substrate 10 includes a curable resin layer 12 on one face 10A (a face to which the microstructure is to be transferred), as illustrated in FIG. 1. The receiving substrate 10 in the example shown in FIG. 1 further includes a support substrate 11 that supports the curable resin layer 12.

The curable resin layer 12 is a layer of a resin which can be cured, and can be in a primarily cured state, a B-stage, or a semi-cured state.

The resin of such a curable resin layer 12 can deform in conformity with a surface shape of the microstructure. By curing the curable resin layer 12 (for example, secondary curing), the resin of the curable resin layer 12 can exhibit high hardness while conforming to the surface shape of the microstructure, thereby holding the microstructure. Therefore, it is possible to prevent local stress from being applied to the microstructure even during laser lift-off (LLO), and also firmly hold the microstructure. Accordingly, the receiving substrate 10 of the present invention can receive the microstructure while suppressing damage, and also prevent displacement and a tilt.

Hereinafter, the curable resin layer 12 and the support substrate 11 will be described in more detail.

### <Curable Resin Layer>

The resin of the curable resin layer 12 used in the present invention is not particularly limited as long as it is curable. For example, the resin is a photo-curable or thermosetting resin.

The resin of the curable resin layer 12 may be, for example, a two-stage curing resin in a B-stage. By virtue of subjecting such a resin layer 12 to a secondary curing process after the resin layer 12 receives the microstructure, such a resin layer 12 can hold the microstructure without displacing or tilting.

The resin in the B-stage of the two-stage curing resin may be, for example, the two-stage curable silicone-based composition having been subjected to the primarily curing.

The two-stage curable silicone-based composition is, for example, a silicone-based composition that can be cured in at least two steps, through a combination of at least two types of curing reactions selected from an addition curing reaction, a photo-radical polymerization reaction, a thermal radical polymerization reaction, a cationic curing reaction, an anionic curing reaction, and a condensation curing reaction. The curing forms may be freely combined as long as they do not inhibit each other's curing reactions. Among them, in view of ease of resin design or curing, preferred for use are a combination of an addition curing reaction and a photo-radical polymerization reaction, a combination of an addition curing reaction and a thermal radical polymerization reaction, and a photo-radical polymerization reaction and a thermal radical polymerization reaction. In particular, in view of ease of design and curing, the combination of the addition curing reaction and the photo-radical polymerization reaction is preferred. At least two types of curing reactions are not particularly limited as long as it includes two or more types, and can include, for example, two or more and four or less types.

After an application step onto the support substrate 11, a primarily-cured curable silicone-based resin layer can be formed under curing conditions suitable for the silicone-based composition, for example, by heat curing preferably in environment at 20 to 200°C for 5 to 90 minutes in a case of the primary curing through a hydrosilylation reaction, or by irradiating the composition with ultraviolet ray preferably in nitrogen environment at an illuminance of 50 to 3000 mW/cm² and a cumulative amount of light of 100 to 20000 mJ/cm², using 365 nm light as an index, in a case of the primary curing through a photo-radical polymerization reaction.

Here, a storage modulus at 25°C of the curable resin layer 12 after the primary curing is preferably 10 to 1000 Pa, particularly preferably 100 to 500 Pa. Unlike liquid, it is easy for the resin layer having the storage modulus at 25°C of 10 to 1000 Pa to keep in-plane uniformity. Furthermore, it becomes easy for the curable resin layer to conform to a protrusion-and-recess of the microstructure.

When the obtained curable resin layer 12 is subjected to secondary curing, the secondarily-cured resin layer (for example, the silicone-based resin layer) can be formed under curing conditions suitable for the curable silicone-based composition, for example, by heat curing preferably in environment at 20 to 200°C for 5 to 90 minutes in a case of the secondary curing through a hydrosilylation reaction, or by irradiating the composition with ultraviolet ray preferably in nitrogen environment at an illuminance of 50 to 3000 mW/cm² and a cumulative amount of light of 100 to 20000 mJ/cm², using 365 nm light as an index, in a case of the secondary curing through a photo-radical polymerization reaction.

Here, the curable resin layer 12 preferably exhibits a storage modulus at 25°C of 1 MPa to 30 GPa, more preferably 4 MPa to 5 GPa, by virtue of curing (secondary curing) thereof. When the storage modulus at 25°C is 1 MPa or more after the secondary curing, it is possible to secure enough holding power for the microstructure, and sufficiently prevent falling off during cleaning, for example. Furthermore, when the storage modulus at 25°C is 30 GPa or less after the secondary curing, it is possible to exert the holding power sufficient for application to the next step.

The curable resin layer 12 is preferably in a gel form, for example, a silicone-based gel layer. The resin layer in a gel form can more reliably prevent damage to the microstructure during laser lift-off. Note that in the present invention, a gel form means that a liquid loses its fluidity to be in a jellylike state, and its surface has tackiness.

The curable resin layer 12 preferably has tackiness to the microstructure. Such resin layer can further prevent displacement of the received microstructure.

The curable resin layer 12 preferably exhibits increased hardness by virtue of curing thereof. The resin layer that exhibits increased hardness by virtue of curing thereof can further control displacement and a tilt of the microstructure after the curing.

Alternatively, the curable resin layer 12 also preferably exhibits increased adhesive strength to the microstructure by virtue of curing thereof, or exhibits increased holding power for the microstructure by virtue of curing thereof. Such a resin layer can further control displacement and a tilt of the microstructure after the curing.

Alternatively, it is also preferable that the curable resin layer 12 is to be in a rubber form by virtue of curing thereof. The resin layer that is to be in a rubber form by virtue of curing thereof can further control displacement and a tilt of the microstructure after the curing. Note that in the present invention, a rubber form means a state of exhibiting resilience against load or impact, with excellent flexibility and elasticity.

Additionally, the curable resin layer 12 may become a cured product of the resin, such as high-hardness plastics, rather than in a rubber form, by virtue of curing thereof.

### <Support Substrate>

Examples of the support substrate 11 used for the receiving substrate 10 include a synthetic quartz glass substrate, a float glass substrate, and the like. In particular, a synthetic quartz glass substrate is preferred from the viewpoints of flatness and transparency.

Furthermore, a size of the support substrate 11 used for the receiving substrate 10 is preferably equal to or larger than a diameter of the supply substrate to be used (described later in detail). Specifically, in a case of using a sapphire substrate having an outer diameter of 10.16 cm (4 inches) as the supply substrate, the receiving substrate 10 having an outer diameter of 10.16 to 20.32 cm (4 to 8 inches) is usable.

In order to ensure to transfer a part or all of a plurality of microstructures from the supply substrate to the receiving substrate 10, it is preferable to bond a plurality of microstructures formed on one face of the supply substrate with the receiving substrate 10 provided with the curable resin layer 12 on the support substrate 11 such that the respective microstructures are temporarily and uniformly fixed to the curable resin layer 12 of the receiving substrate 10.

In order to accurately and temporarily fix the microstructures in such a manner, the support substrate 11 used for the receiving substrate 10 preferably has a power spectral density of 10¹² nm⁴ or less at a spatial frequency of 1 mm⁻¹ or more, as measured for a 6.01 mm × 6.01 mm region at a pixel count of 1240 × 1240 using a white-light interferometer. Particularly, when the microstructures are micro-LEDs, a power spectral density at a spatial frequency of 10 mm⁻¹ or more and 50 mm⁻¹ or less is preferably 10⁹ nm⁴ or less by taking into consideration the distance between the microstructures, as measured for a 6.01 mm × 6.01 mm region at a pixel count of 1240 × 1240 using a white-light interferometer.

Moreover, for accurate temporal fixation of the microstructures to the receiving substrate 10, the support substrate 11 used for the receiving substrate 10 preferably has small thickness variation. For example, a total thickness variation (TTV) measured by a wavelength conversion type Fizeau flatness tester manufactured by Mizojiri Optical Co., Ltd. is preferably 2 µm or less, more preferably 1 µm or less, and further preferably 0.5 µm or less.

Note that the microstructure to be held by the receiving substrate 10 of the present invention may be a microstructure having a projection or a microstructure with no projection.

### Method for Producing Receiving Substrate

The receiving substrate of the present invention can be produced, for example, by a method for producing a receiving substrate of the present invention as described below with reference to FIG. 2. However, the receiving substrate of the present invention can also be produced by methods other than the method for producing a receiving substrate of the present invention as described below.

Firstly, as illustrated in FIG. 2(A), a substrate (support substrate) 11 for producing a receiving substrate is provided. Regarding the details of the support substrate to be used, please refer to the description above.

Next, as illustrated in FIG. 2(B), a step of forming, on one face of the support substrate 11, a resin layer 12a capable of undergoing at least two types of curing reactions is performed to obtain a composite 10a.

This step can include, for example, coating the support substrate 11 with a resin that is capable of undergoing at least two types of curing reactions.

The resin used herein is not particularly limited as long as it is capable of undergoing at least two types of curing reactions. For example, the two-step curable silicone-based composition as previously described can be used.

When the two-stage curable silicone-based composition as previously described is used as the resin that is capable of undergoing at least two types of curing reactions, the two-stage curable silicone-based composition in any shape may be applied onto the support substrate 11, using spin coating, slit coating, screen printing, or the like. An application thickness of the two-stage curable silicone-based composition may be optionally determined in consideration of a shape and a thickness of the microstructure to be transferred, but is preferably 1 to 500 µm, more preferably 5 to 200 µm, and further preferably 10 to 100 µm from the viewpoints of ease of application and maintaining of film thickness uniformity after curing. Moreover, in order to improve adhesion or adhesiveness at an interface between the support substrate 11 and the curable silicone-based resin 12a, the support substrate 11 treated with a primer in advance may be used.

Next, a step of performing a first type of curing reaction (so-called primary curing) to partially cure the resin in the resin layer 12a is performed, where the resin is capable of undergoing at least two types of curing reactions. In this manner, the resin layer 12a is primarily cured to become the curable resin layer 12. As a result, the receiving substrate 10 of the present invention shown in FIG. 2(C) can be obtained.

The curable resin layer 12 can undergo secondary curing. By virtue of the secondary curing thereof, the curable resin layer 12 can become a secondarily cured resin layer 12b shown in FIG. 2(D). In other words, a receiving substrate 10b shown in FIG. 2(D) includes the support substrate 11 and the secondarily cured resin layer 12b formed on the support substrate 11.

At least two types of curing reactions as described above (for example, primary curing and secondary curing) can include, for example, a combination of a photo-curing reaction and a thermosetting reaction, a combination of thermosetting reactions with different curing start temperatures, or a combination of photo-curing reactions with different curing wavelengths.

In another aspect, at least two types of curing reactions as described above (for example, primary curing and secondary curing) can include, for example, a combination of at least two selected from the group consisting of a radical curing system, a cationic curing system, an anionic curing system, an addition curing system, and a condensation curing system.

### [LIFT Method]

The LIFT method of the present invention is to transfer a microstructure formed on a supply substrate to a receiving substrate by laser lift-off. An example of the LIFT method according to the present invention will be described with reference to FIGS. 3 to 8.

As the receiving substrate to be used in the LIFT method of the present invention, the receiving substrate 10 of the present invention as previously described can be used.

The supply substrate usable in the present invention is, for example, a supply substrate 20 in which a plurality of microstructures 100 are formed on one face of a support substrate 21, and projections 130 are provided on a face 100A of the microstructure 100 opposite to the receiving substrate 10, as shown in FIG. 3. In FIG. 3, the projections 130 such as Bumps are formed on a device body 120 of the microstructure 100. Between the projections 130, a recess 110 is formed. Note that by virtue of the use of the above-described receiving substrate of the present invention, the microstructure having no projection can be transferred by laser lift-off.

Examples of the support substrate 21 used for the supply substrate 20 include a sapphire substrate, a GaAs substrate (gallium arsenide substrate), a Si substrate, a SiC substrate, and the like, which can have any diameter.

Furthermore, an example of the microstructure 100 is a device obtained by providing a basic structure of a device on the support substrate 21 by a process usually performed in a semiconductor pre-process, such as epitaxial growth, ion implantation, wet etching, dry etching, vapor deposition, and electrode formation, and thereafter separating the basic structure into devices by a common method such as blade dicing, dry etching, and laser dicing to a depth required for the separation.

For example, when the microstructure is a LED, a LED epitaxial substrate including an epitaxial layer having a total thickness of 4 µm is prepared, where a buffer layer is provided on a 10.16 cm (4 inches) sapphire substrate, a 3 µm N-type GaN layer is formed, a known light-emitting layer structure is then provided, and a P-type GaN is stacked thereon. Thereafter, the N-layer is locally exposed by dry etching, a P-type electrode is then formed on the P-layer by a known process, a N-type electrode is formed to be in contact with the exposed N-layer, and a Bump is formed on the electrode by plating, vapor deposition, sputtering, or other methods. Then, to perform the separation into the LED devices each having a predetermined size, laser dicing is performed to reach at least the sapphire substrate to achieve the complete separation into the devices, thereby obtaining the microstructure.

Furthermore, the microstructure 100 has any size, for example, about 1 mm square in a case of a power LED. Besides this, the size is about 300 µm square in a case of a LED device, about 100 µm square in a case of a mini-LED, about 60 µm square or less in a case of a micro-LED, and 30 µm square or less in a case of a minimum size micro-LED.

Note that described above is an example of the microstructure 100 having a generally square shape, but the present invention is not limited thereto. For example, in a case of a micro-LED, the microstructure 100 may have a rectangular shape with one side being 30 to 60 µm and the other side being 10 to 30 µm.

Furthermore, a thickness of the microstructure 100 depends on a thickness of the epitaxial growth on the support substrate 21 and is not particularly limited, but preferably about 3 to 10 µm.

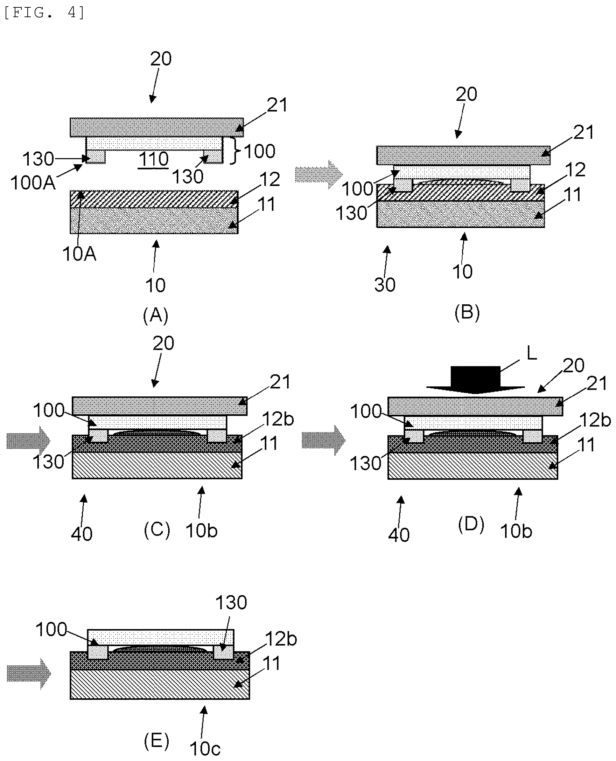

By the way, in the LIFT method in this example, for example, as illustrated in FIG. 4(A), the receiving substrate 10 and the supply substrate 20 are aligned with each other such that the face 10A of the curable resin layer 12 of the receiving substrate 10, to which the microstructure 100 is to be transferred, is opposite to the projections 130 provided on the face 100A of the microstructure 100 of the supply substrate 20.

Next, as illustrated in FIG. 4(B), the microstructure 100 is pressed against the curable resin layer 12 to embed the projections 130 in the curable resin layer 12, thereby obtaining a laminate substrate 30. This step can also be referred to as bonding.

Next, as illustrated in FIG. 4(C), by curing the curable resin layer 12 with the projections 130 embedded in the curable resin layer 12, the microstructure 100 is held onto the receiving substrate 10. This step can also be referred to as the secondary curing.

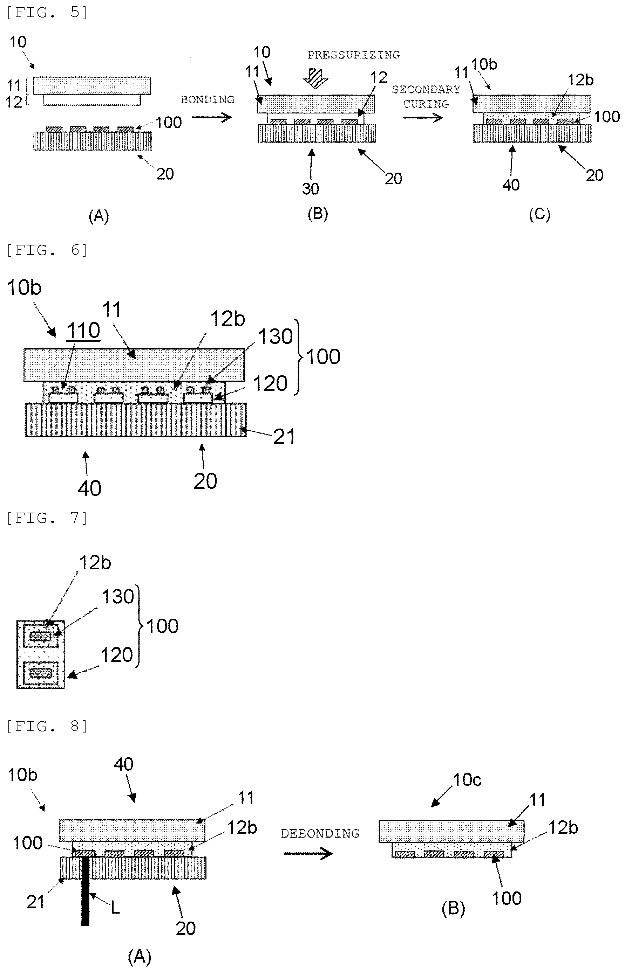

In another example, the bonding between a plurality of microstructures 100 formed on one face of the supply substrate 20 and the curable resin layer (for example, silicone-based resin layer) 12 on the receiving substrate 10, as well as the secondary curing can be performed as illustrated in FIG. 5, for example. It should be noted that the projections of the microstructures 100 are omitted in FIG. 5.

In this example, from the aligned state in FIG. 5(A), the receiving substrate 10 and the supply substrate 20 as a whole are bonded to each other under pressurizing such that the microstructures 100 on the supply substrate 20 and the curable resin layer 12 on the receiving substrate 10 face each other as illustrated in FIG. 5(B), thereby obtaining a laminate 30.

Subsequently, as illustrated in FIG. 5(C), the secondary curing of the curable resin layer 12 is performed to impart high hardness to the secondarily cured resin layer 12b, thereby obtaining a laminate substrate 40.

FIGS. 6 and 7 show the details of FIG. 5(C). FIG. 7 is a schematic illustration of the microstructure 100 as observed through the support substrate 11 in the laminate substrate 40 of FIG. 6. The microstructure 100 to be transferred by the LIFT method of the present invention has the projections 130 as previously described. In FIGS. 6 and 7, the projections 130 such as Bumps are covered with the secondarily cured resin layer 12b without any space. Therefore, the recess 110 of the microstructure 100 shown in FIG. 3 is filled with the resin layer 12b.

When there are no air bubbles in the resin layer 12b within 5 µm from the projections 130, it is possible to prevent the projections 130 from coming in contact with a cleaning liquid in a cleaning step, thereby preventing change in the component constituting the projections 130. For example, a laser microscope or the like can be used to confirm that there are no air bubbles in the resin 12b within 5 µm from the projections 130.

The pressurizing during the bonding is preferably performed such that no air bubbles will remain between the curable resin layer 12 and the microstructure 100. For example, the bonding is preferably performed by applying a load of preferably 0.05 to 1.0 MPa, more preferably 0.10 to 0.5 MPa. Further in this event, in order to make it easier for the curable resin layer 12 to conform to the shape of the microstructure, the pressurizing may be performed under reduced pressure. Moreover, when the secondary curing of the curable resin is caused by heating, heating may be performed simultaneously with the bonding to cause the secondary curing.

The secondarily cured resin layer 12b is formed under curing conditions suitable for the curable silicone-based resin to be used, such as by charging the curable resin layer 12 into a heating furnace preferably in environment at 80 to 200°C for 5 to 90 minutes when the secondary curing of the curable resin layer 12 is based on a hydrosilylation reaction, or by irradiating the composition with ultraviolet ray preferably in nitrogen environment at an illuminance of 50 to 3000 mW/cm² and a cumulative amount of light of 100 to 20000 mJ/cm², using 365 nm light as an index, when the secondary curing is based on a photo-radical polymerization reaction.

Next, as illustrated in FIGS. 4(D) and 8(A) (the projections of the microstructure 100 is omitted), laser lift-off is performed with a laser light L in a state that the microstructure 100 is held onto the receiving substrate 10. The laser lift-off performed in this state can also be referred to as contact laser lift-off (CLLO).

More specifically, the laminate substrate 40 obtained by the bonding and secondary curing steps is irradiated with the laser light L by pulsed oscillation, for example, from the opposite side of the face of the supply substrate 20 on which the microstructure 100 is formed, thereby peeling the microstructure 100 from the support substrate 21. Thus, the microstructure 100 can be transferred from the supply substrate 20 to the secondarily cured resin layer 12b on the receiving substrate 10.

In the LLO step, for example, when the microstructure 100 is a gallium nitride microstructure fixed to the support substrate 21 of the supply substrate 20, such as a sapphire substrate, irradiation with laser light such as excimer laser and YAG laser dissolves the gallium nitride in the irradiated portion, thereby enabling to peel the gallium nitride microstructure 100 from the supply substrate 20. In this case, KrF excimer laser light is preferably used, particularly for a micro-LED from the viewpoint of reliability of the microstructure 100.

Specifically, the laser light is selectively applied to cause laser ablation at the interface between the microstructure 100 to be selected and the support substrate 21 of the supply substrate 20. In the case of the gallium nitride microstructure, for example, this results in decomposition of the gallium nitride into metal gallium and nitrogen to generate gas between the microstructure 100 to be selected and the support substrate 21 of the supply substrate 20, which makes it relatively easy to peel off the microstructure 100.

After irradiating all the microstructures 100 as transfer targets with the laser light L in the same manner and transferring the same, for example, as illustrated in FIGS. 4(E) and 8(B) (the projections of the microstructure 100 is omitted), the receiving substrate 10b to which the microstructures 100 are transferred and the support substrate 21 of the supply substrate 20 can be debonded from each other. In this manner, a receiving substrate 10c holding the microstructures 100 can be obtained.

Since the supply substrate 20 and the microstructure 100 are separated from each other in the LLO step, the supply substrate 20 can be easily debonded using a proper tool.

According to the LIFT method of the present invention as described above, by performing the laser lift-off with the projections 130 of the microstructure 100 embedded in the curable resin layer 12, local stress can be prevented from being applied to the microstructure 100 during the laser lift-off. Thus, according to the LIFT method of the present invention, it is possible to transfer also the microstructure 100 having the projections 130 from the supply substrate to the receiving substrate while preventing damage. Furthermore, high hardness can be imparted to the curable resin layer 12 of the receiving substrate 10 used in the LIFT method of the present invention by virtue of curing thereof while holding the microstructure 100. Thus, according to the LIFT method of the present invention, it is possible to hold the microstructure 100 onto the receiving substrate 10 while controlling displacement and a tilt of the received microstructure 100.

The receiving substrate 10c may be directly used in the next step, or may be used in the next step after a cleaning step with an acidic or alkaline cleaning liquid as described later or after surface cleaning with oxygen plasma or argon plasma.

The microstructure 100 transferred onto the receiving substrate 10c through the LIFT method of the present invention or further through a cleaning method as described later can be mounted on a circuit board, for example, using the stamp member for transfer described in Patent Document 1, or through a desired step, such as transferring again the microstructure 100 to a polyimide layer. In other words, the receiving substrate 10c can also be used in another step as a supply substrate (donor substrate) that supplies the microstructure 100 to another substrate.

### Holding Method

The bonding and the secondary curing shown in FIGS. 4(B) and 4(C) as well as FIG. 5 can also be referred to as a holding method of the present invention. That is, the holding method of the present invention for holding the microstructure 100 having the projections 130 onto the receiving substrate 10 is a method wherein the receiving substrate 10 has a curable resin layer 12 on a face onto which the microstructure 100 is to be held, the method including: pressing the microstructure 100 against the curable resin layer 12 to embed the projection 130 in the curable resin layer 12; and curing the curable resin layer 12 while keeping the projection 130 embedded in the curable resin layer 12, thereby holding the microstructure 100 onto the receiving substrate 10.

According to such a holding method, by curing the curable resin layer 12 while keeping the projections 130 of the microstructure 100 embedded in the curable resin layer 12, the microstructure 100 can be held onto the receiving substrate 10 while preventing damage, displacement, and a tilt of the microstructure 100.

It should be noted that according to the receiving substrate of the present invention as previously described, even the microstructure having no projection can be held by performing the secondary curing of the curable resin layer in a state that the contact face of the microstructure is pushed in the curable resin layer.

### Cleaning Method

In one aspect of a cleaning method of the present invention, the microstructure 100 is transferred to the receiving substrate 10 by the lift-off method of the present invention as described above, and thereafter the microstructure 100 is cleaned with an acidic or alkaline cleaning liquid.

In another aspect, the cleaning method of the present invention is a method for cleaning the microstructure 100 having the projections 130 as shown in FIG. 3, for example, the method including: pressing the microstructure 100 against a curable resin layer 12, as, for example, shown in FIG. 5, to embed the projection 130 in the curable resin layer 12; and curing the curable resin layer 12 as, for example, shown in FIGS. 6 and 7, and thereafter cleaning the microstructure 100 with an acidic or alkaline cleaning liquid in a state that the projection 130 of the microstructure 100 is covered with the resin layer 12b without any space or any air bubbles in the resin layer 12b within 5 µm from the projection 130.

Hereinafter, the cleaning method of the present invention will be described in more detail.

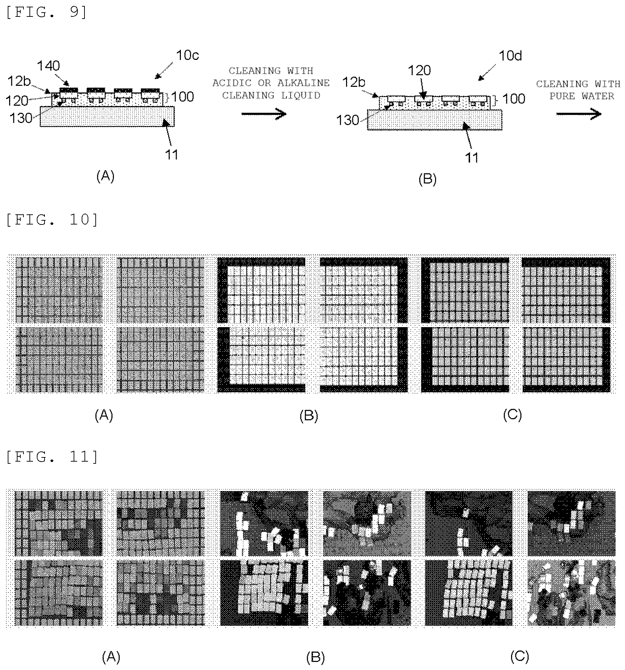

FIG. 9 schematically shows an example of the cleaning method according to the present invention, i.e. an aspect during cleaning of a metal Ga after completing the LLO step and peeling off as shown in FIG. 8.

In FIG. 9(A), the secondarily cured resin layer 12b holding the microstructure 100 is on the receiving substrate 10c after the LLO step, and a metal (for example, Ga) 140 is attached to a surface of the microstructure 100 on the opposite side of the resin layer 12b. Here, the interface between the resin 12b and the microstructure 100 is in a tightly adhered state. Therefore, by immersing the whole receiving substrate 10 in this state in the acidic or alkaline cleaning liquid, or by washing the receiving substate 10 with the acidic or alkaline cleaning liquid, the metal 140 can be dissolved and removed as shown in FIG. 9(B), thereby obtaining a receiving substrate 10d holding the transferred microstructure. In this event, the interface on the resin 12b side of the microstructure 100 is covered with and held by the resin 12b, so that it is not affected by the acidic or alkaline cleaning liquid, nor distilled off in the cleaning step. The receiving substrate 10d is further washed thoroughly with pure water, dried by air or the like, and then used in the next step.

In these cleaning steps, the microstructure 100 is held onto the resin layer 12b, and remains on the surface of the resin 12b without falling off. Moreover, displacement and a tilt can also be prevented by holding the microstructure 100 onto the resin layer 12b.

Particularly, in the example shown in FIG. 9, since all the projections 130 of the microstructure 100 are covered with the resin layer 12b without any space or any air bubbles in the resin 12b within 5 µm from the projections 130, it is possible to prevent the projections 130 from being affected by acid or alkali in the cleaning step.

Further, by performing the cleaning step while the resin 12b and the device body 120/projections 130 are tightly adhered to each other with no air space of 1 µm or more at the longest at the interface between them, it is possible to prevent effects on the composition of the device body 120 at the interface on the resin layer 12b side and the composition of the Bump (when the projections 130 are Bumps), and use them in the next step with no problem.

When the cleaning liquid in the cleaning step is the acidic cleaning liquid, a homogeneous mixture of concentrated hydrochloric acid, concentrated nitric acid, concentrated sulfuric acid, or the like with pure water in any proportions can be used, or a plurality type of acid aqueous solutions may be used. In this event, the cleaning liquid preferably has pH of 0 to 4.0. The pH within this range enables to sufficiently utilize a property of dissolving the metal (for example, Ga) 140.

Moreover, in the case of the alkaline cleaning liquid, sodium hydroxide, potassium hydroxide, ammonium hydroxide, magnesium hydroxide, tetramethylammonium hydroxide, tetrabutylammonium hydroxide, sodium carbonate, sodium hydrogencarbonate, and potassium acetate dissolved in pure water at any concentration can be used, or a plurality of alkaline cleaning liquids may be used. In this event, the cleaning liquid preferably has pH of 9.5 to 14.0. The pH within this range enables to sufficiently utilize a property of dissolving the metal (for example, Ga) 140.

As previously described, the receiving substrate of the present invention can also hold the microstructure having no projection. Therefore, in a variation of the cleaning method of the present invention, it is also possible to clean the microstructure having no projection while holding it onto the receiving substrate of the present invention.

The present invention described above is applicable to manufacturing processes of LED displays particularly for use in signage, TVs, medical applications, in-vehicle displays, smartphones, etc.

### EXAMPLES

Hereinafter, the present invention will be specifically described with reference to Examples and Comparative Examples. However, the present invention is not limited thereto.

Supply substrates including the following microstructures were respectively provided.

### <Supply Substrate A and Microstructure A>

90 × 140 µm sapphire substrate with a total thickness of 19 µm, cut into a 1.5 cm square, on which mini-LED devices with a Bump height of 7 µm were mounted

### <Supply Substrate B and Microstructure B>

18 × 36 µm sapphire substrate with a total thickness of 9 µm, cut into a 1.5 cm square, on which micro-LED devices with a Bump height of 4 µm were mounted

Furthermore, as a support substrate for the receiving substrate, the following one was provided.

### <Support Substrate Used for Receiving Substrate>

Synthetic quartz substrate with an outer diameter of 15.24 cm (6 inches), a thickness of 1 mm, and a total thickness variation (TTV) of 0.8 µm

### <Experiment Description: Examples 1 to 5>

### Fabrication of Receiving Substrate

On the support substrate, 3 g of a two-stage curable silicone resin composition (silicone A or B) shown below was added dropwise, and uniformly applied onto the support substrate to have a film thickness of 30 µm using a spin coater. The coating film thus obtained was subjected to primary curing conditions described below to primarily cure the silicone resin composition into a gel form, thereby fabricating the receiving substrate including the curable silicone resin.

### Bonding

The supply substrate and the receiving substrate were bonded to each other under pressurizing at 0.5 MPa such that the microstructure on the supply substrate and the curable silicone resin on the receiving substrate respectively shown in Table 1 below came in contact with each other. Then, secondary curing of the curable silicone resin was performed under the following conditions. Thereafter, a laser microscope was used to confirm whether there was no air space of 1 µm or more at the longest between the supply substrate/microstructure and the secondarily cured silicone resin, and whether there were no air bubbles in the resin within 5 µm from the projection.

### LLO and Debonding

Next, the microstructure was irradiated with KrF excimer laser light from the back face of the supply substrate to perform LLO. Thereafter, the supply substrate was debonded from the receiving substrate.

After the debonding, a transfer rate of the microstructures from the supply substrate onto the receiving substrate and a failure rate were evaluated. The results thereof are shown in Table 1 below.

Thereafter, the microstructure was cleaned by immersing its surface in the acidic or alkaline cleaning liquid shown below and Table 1 for 3 minutes. Next, a cleaning step by means of immersion in pure water for 3 minutes was repeated twice, and air-drying was performed.

After the air-drying, presence/absence of a tilt and falling off of the microstructure were confirmed. The results thereof are shown below.

Acidic cleaning liquid: 12 mass% hydrochloric acid aqueous solution
Alkaline cleaning liquid: 5 mass% potassium hydroxide aqueous solution

### Elastic Modulus Measurement

Dynamic viscoelasticity properties of the silicone-based gel cured product in the present invention were defined by a storage modulus G' at characteristic frequency and a specific temperature, and measured using a viscoelasticity measurement device ARES G-II manufactured by TA Instruments. The silicone resin cured and molded into a 3 cm square with a thickness of 500 µm was sandwiched between the circular measurement section of the tester and a parallel plate with a diameter of 20 mm without trapping any air bubbles in there, and measured for 10 minutes at a strain value of 4% and a frequency of 1 Hz with the temperature kept at 25°C. The value 10 minutes after the start of the measurement was read as the storage modulus G'. The silicone resin after the secondary curing was also measured using the same procedure and conditions. The results thereof are shown below.

Silicone A: Two-stage curable silicone composition that was primarily cured by an addition reaction in environment at 120°C × 1h to become a gel form with the storage modulus G' of 0.2 kPa, and then irradiated with 365 nm UV-LED 3000 mJ/cm² (illuminance: 100 mW/cm²) under nitrogen to undergo a photo-radical reaction so as to be secondarily cured into a rubber form with the storage modulus G' of 8.2 MPa

Silicone B: Two-stage curable silicone composition that was irradiated with 365 nm UV-LED 3000 mJ/cm² (illuminance: 100 mW/cm²) under nitrogen to undergo a photo-radical reaction so as to be primarily cured into a gel form with the storage modulus G' of 5 kPa, and then secondarily cured by an addition reaction in environment at 120°C × 1h to become a rubber form with the storage modulus G' of 4GPa.

### <Experiment Description: Comparative Examples 1 to 4>

The transfer rate, the failure rate, and displacement of the microstructures in the LLO step, and a tilt and presence/absence of falling off of the microstructures in the cleaning step were respectively confirmed according to the same steps as in Examples, except that the following silicone composition (silicone C) was cured into a rubber form only under a single curing condition to fabricate the receiving substrate. That is, the receiving substrate used in Comparative Examples 1 to 4 did not have a curable resin layer.

The elastic modulus of the silicone C cured into a rubber form was measured according to the procedure as previously described.

Silicone C: Heat-curable silicone composition that is to be cured by an addition reaction in environment at 120°C × 1h to become a rubber form with the storage modulus G' of 4.7 Mpa

**[Table 1]**

| | Example 1 | Example 2 | Example 3 | Example 4 | Example 5 | Comparative Example 1 | Comparative Example 2 | Comparative Example 3 | Comparative Example 4 |
|---|---|---|---|---|---|---|---|---|---|
| Silicone Type | Silicone A | Silicone B | Silicone B | Silicone B | Silicone B | Silicone C | Silicone C | Silicone C | Silicone C |
| Microstructure Type | Microstructure A | Microstructure A | Microstructure A | Microstructure B | Microstructure B | Microstructure A | Microstructure A | Microstructure B | Microstructure B |
| Presence/Absence of: Space at Interface between Silicone and Microstructures; and Presence/Absence of Air Bubbles in Silicone | Both Absent | Both Absent | Both Absent | Both Absent | Both Absent | With space Silicone not in conformity with projections of microstructures, impossible to determine presence/absence of air bubbles | | | |

| LLO step | | | | | | | | | |
|---|---|---|---|---|---|---|---|---|---|
| Transfer Rate of Microstructures [%] | ≥99 | ≥99 | ≥99 | ≥99 | ≥99 | ≥99 | ≥99 | ≥99 | ≥99 |
| Failure Rate of Microstructures [%] | <1 | <1 | <1 | <1 | <1 | 20 | 20 | 5 | 5 |
| Displacement of Microstructures | No | No | No | No | No | Yes | Yes | No | No |

| Cleaning step | | | | | | | | | |
|---|---|---|---|---|---|---|---|---|---|
| Cleaning Liquid | 5 mass% KOH aq. | 12 mass% HCl aq. | 5 mass% KOH aq. | 12 mass% HCl aq. | 5 mass% KOH aq. | 12 mass% HCl aq. | 5 mass% KOH aq. | 12 mass% HCl aq. | 5 mass% KOH aq |
| Tilt of Microstructures | No | No | No | No | No | Yes | Yes | Yes | Yes |
| Falling off of Microstructures | No | No | No | No | No | Yes | Yes | No | Yes |

Furthermore, FIG. 10 shows photographs of the microstructures after transfer by LLO (FIG. 10(A)), the debonded microstructure subsequent to this transfer (FIG. 10(B)), and the cleaned microstructure subsequent to this debonding (FIG. 10(C)) in Example 1.

The respective aspects of the microstructures after transfer by LLO, the debonded microstructures subsequent to this transfer, and the cleaned microstructures subsequent to this debonding in Examples 2 to 5 were similar to those shown in FIGS. 10(A), 10(B), and 10(C).

As can clearly been seen from the results shown in the above Table 1 and FIG. 10, in Examples 1 to 5, the microstructures each having the projection were transferred from the supply substrate to the receiving substrate with the transfer rate of 99% or more, without any damage or displacement.

Moreover, as can clearly be seen from the results shown in the above Table 1 and FIG. 10, in Examples 1 to 5, falling off and tilts of the microstructures were not observed after the cleaning.

In Examples 1 to 5, these results are due to the facts that the primarily-cured silicone-based resin layer received the microstructures with their projections embedded in the primarily-cured silicone-based resin layer, and high hardness was imparted to the silicone-based resin layer in this state by virtue of the secondary curing thereof, so that the secondarily-cured silicone-based resin layer was capable of sufficiently holding the microstructures, thereby preventing damage, falling off, displacement, and tilts of the microstructures in the steps of transferring by LLO, debonding, and cleaning.

On the other hand, in Comparative Examples 1 to 4, due to using of the receiving substrate not including a curable resin but including the cured rubber resin, the failure rate was 5% or more. Additionally, in Comparative Examples 1 and 2, displacement of the microstructures was also recognized. Furthermore, as can clearly be seen from the results shown in Table 1, tilts of the microstructures was observed after the cleaning in Comparative Examples 1 to 4.

Furthermore, as a reference example, LLO, debonding, and cleaning were performed in the same manner as in Example 1 except that the secondary curing of the curable resin layer was not performed upon LLO. FIG. 11 shows photographs of the microstructures after transfer by LLO (FIG. 11(A)), the debonded microstructures subsequent to this transfer (FIG. 11(B)), and the cleaned microstructures subsequent to this debonding (FIG. 11(C)) in the reference example.

In the reference example, displacement of the microstructures occurred during LLO, and the transfer rate was also low. Further, in the reference example, the microstructure that did not get on the secondarily-cured silicone-based resin layer during LLO was broken.

Further in the reference example, as can clearly be seen in FIGS. 11(B) and 11(C), falling off, displacement, and tilts of the microstructures caused by debonding and cleaning were observed.

The present description includes the following embodiments.
[1] A receiving substrate for receiving a microstructure formed on a supply substrate and transferred by laser lift-off, wherein the receiving substrate comprises a curable resin layer on a face to which the microstructure is to be transferred.
[2] The receiving substrate according to [1], wherein the curable resin layer is a photo-curable or thermosetting resin layer.
[3] The receiving substrate according to [1] or [2], wherein the curable resin layer is in a B-stage.
[4] The receiving substrate according to any one of [1] to [3], wherein the curable resin layer is in a gel form.
[5] The receiving substrate according to any one of [1] to [4], wherein the curable resin layer is a silicone-based gel layer.
[6] The receiving substrate according to any one of [1] to [5], wherein the curable resin layer has tackiness to the microstructure.
[7] The receiving substrate according to any one of [1] to [6], wherein the curable resin layer exhibits increased hardness by virtue of curing thereof.
[8] The receiving substrate according to any one of [1] to [7], wherein the curable resin layer exhibits increased adhesive strength to the microstructure by virtue of curing thereof, or exhibits increased holding power for the microstructure by virtue of curing thereof.
[9] The receiving substrate according to any one of [1] to [8], wherein the curable resin layer is to be in a rubber form by virtue of curing thereof.
[10] The receiving substrate according to any one of [1] to [9], wherein the curable resin layer has a storage modulus at 25°C of 10 to 1000 Pa, and exhibits a storage modulus of 1 MPa to 30 GPa by virtue of curing thereof.
[11] A method for producing a receiving substrate having a curable resin layer, comprising the steps of: forming a resin layer on one face of a substrate for producing a receiving substrate, the resin layer being capable of undergoing at least two types of curing reactions; and performing a first type of curing reaction to partially cure the resin.
[12] The method for producing a receiving substrate according to [11], wherein the at least two types of curing reactions include a combination of a photo-curing reaction and a thermosetting reaction, a combination of thermosetting reactions with different curing start temperatures, or a combination of photo-curing reactions with different curing wavelengths.
[13] The method for producing a receiving substrate according to [11] or [12], wherein the at least two types of curing reactions include a combination of at least two selected from the group consisting of a radical curing system, a cationic curing system, an anionic curing system, an addition curing system, and a condensation curing system.
[14] A LIFT method for transferring a microstructure formed on a supply substrate to a receiving substrate by laser lift-off, wherein the microstructure has a projection on a face opposite to the receiving substrate, and the receiving substrate comprises a curable resin layer on a face to which the microstructure is to be transferred, the method comprising: pressing the microstructure against the curable resin layer to embed the projection in the curable resin layer; curing the curable resin layer with the projection embedded in the curable resin layer, thereby holding the microstructure onto the receiving substrate; and performing laser lift-off with the microstructure held onto the receiving substrate.
[15] A method for holding a microstructure having a projection onto a receiving substrate, wherein the receiving substrate has a curable resin layer on a face onto which the microstructure is to be held, and the method comprising: pressing the microstructure against the curable resin layer to embed the projection in the curable resin layer; and curing the curable resin layer while keeping the projection embedded in the curable resin layer, thereby holding the microstructure onto the receiving substrate.
[16] A method for cleaning a microstructure, comprising: transferring the microstructure to the receiving substrate by the LIFT method according to [14], and thereafter cleaning the microstructure with an acidic or alkaline cleaning liquid.
[17] A method for cleaning a microstructure having a projection, comprising: pressing the microstructure against a curable resin layer to embed the projection in the curable resin layer; and curing the curable resin layer and thereafter cleaning the microstructure with an acidic or alkaline cleaning liquid in a state that the projection of the microstructure is covered with the resin layer without any space or any air bubbles in the resin layer within 5 µm from the projection.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A receiving substrate for receiving a microstructure formed on a supply substrate and transferred by laser lift-off,
wherein the receiving substrate comprises a curable resin layer on a face to which the microstructure is to be transferred.

2. The receiving substrate according to claim **1,** wherein the curable resin layer is a photo-curable or thermosetting resin layer.

3. The receiving substrate according to claim **1,** wherein the curable resin layer is in a B-stage.

4. The receiving substrate according to claim 1, wherein the curable resin layer is in a gel form.

5. The receiving substrate according to claim 1, wherein the curable resin layer is a silicone-based gel layer.

6. The receiving substrate according to claim 1, wherein the curable resin layer has tackiness to the microstructure.

7. The receiving substrate according to claim 1, wherein the curable resin layer exhibits increased hardness by virtue of curing thereof.

8. The receiving substrate according to claim 1, wherein the curable resin layer exhibits increased adhesive strength to the microstructure by virtue of curing thereof, or exhibits increased holding power for the microstructure by virtue of curing thereof.

9. The receiving substrate according to claim 4, wherein the curable resin layer is to be in a rubber form by virtue of curing thereof.

10. The receiving substrate according to claim 4, wherein the curable resin layer has a storage modulus at 25°C of 10 to 1000 Pa, and exhibits a storage modulus of 1 MPa to 30 GPa by virtue of curing thereof.

11. A method for producing a receiving substrate having a curable resin layer, comprising the steps of:
forming a resin layer on one face of a substrate for producing a receiving substrate, the resin layer being capable of undergoing at least two types of curing reactions; and
performing a first type of curing reaction to partially cure the resin.

12. The method for producing a receiving substrate according to claim 11, wherein
the at least two types of curing reactions include a combination of a photo-curing reaction and a thermosetting reaction, a combination of thermosetting reactions with different curing start temperatures, or a combination of photo-curing reactions with different curing wavelengths.

13. The method for producing a receiving substrate according to claim 11, wherein the at least two types of curing reactions include a combination of at least two selected from the group consisting of a radical curing system, a cationic curing system, an anionic curing system, an addition curing system, and a condensation curing system.

14. A LIFT method for transferring a microstructure formed on a supply substrate to a receiving substrate by laser lift-off, wherein
the microstructure has a projection on a face opposite to the receiving substrate, and
the receiving substrate comprises a curable resin layer on a face to which the microstructure is to be transferred,
the method comprising:
pressing the microstructure against the curable resin layer to embed the projection in the curable resin layer;
curing the curable resin layer with the projection embedded in the curable resin layer, thereby holding the microstructure onto the receiving substrate; and
performing laser lift-off with the microstructure held onto the receiving substrate.

15. A method for holding a microstructure having a projection onto a receiving substrate, wherein
the receiving substrate has a curable resin layer on a face onto which the microstructure is to be held, and
the method comprising:
pressing the microstructure against the curable resin layer to embed the projection in the curable resin layer; and
curing the curable resin layer while keeping the projection embedded in the curable resin layer, thereby holding the microstructure onto the receiving substrate.

16. A method for cleaning a microstructure, comprising:
transferring the microstructure to the receiving substrate by the LIFT method according to claim 14, and thereafter cleaning the microstructure with an acidic or alkaline cleaning liquid.

17. A method for cleaning a microstructure having a projection, comprising:
pressing the microstructure against a curable resin layer to embed the projection in the curable resin layer; and
curing the curable resin layer and thereafter cleaning the microstructure with an acidic or alkaline cleaning liquid in a state that the projection of the microstructure is covered with the resin layer without any space or any air bubbles in the resin layer within 5 µm from the projection.
